# FASCICULE DE BREVET EUROPEEN

(11) **EP 2 643 921 B1**
(45) Date de publication et mention de la délivrance du brevet: **07.10.2020**
(21) Numéro de dépôt: 11794560.0
(22) Date de dépôt: 17.11.2011
(51) Int. Cl.: H02K 11/33, H02K 11/04, H01L 25/16

(54) **ARCHITECTURE DE MODULES ELECTRONIQUES DE PUISSANCE INTERCONNECTES POUR UNE MACHINE ELECTRIQUE TOURNANTE ET MACHINE ELECTRIQUE TOURNANTE COMPRENANT UNE TELLE ARCHITECTURE**
VERBUNDENENES ELEKTRONISCHES LEISTUNGSMODULARCHITEKTUR FÜR ELEKTRISCHE MASCHINE UND ELEKTRISCHE MASCHINE MIT EINEM SOLCHEN ARCHITEKTUR
ARCHITECTURE OF INTERCONNECTED ELECTRONIC POWER MODULES FOR A ROTATING ELECTRIC MACHINE AND A ROTATING ELECTRIC MACHINE INCLUDING SUCH AN ARCHITECTURE

(30) Priorité: 23.11.2010 FR 1059629
(43) Date de publication de la demande: 02.10.2013
(73) Titulaire: Valeo Equipements Electriques Moteur, 94046 Créteil Cedex (FR)
(72) Inventeur: SEIDENBINDER, Régis, F-94600 Choisy Le Roi (FR); LAFABRIE, Bryann, F-94000 Creteil (FR); TAUVRON, Fabrice, F-91200 Athis-mons (FR); DHERIPRE, Cyrille, F-62600 Berck Sur Mer (FR); DELPLACE, David, F-62176 Camiers (FR); TUNZINI, Marc, F-78000 Versailles (FR); GUILLARD, Romaric, F-91120 Palaiseau (FR); LOPEZ, Ruth, F-75005 Paris (FR); WEN, Jie, F-92130 Issy Les Moulineaux (FR)
(86) Numéro de dépôt international: PCT/FR2011/052671
(87) Numéro de publication internationale: WO 2012/069737

(56) Documents cités:
- DE-A1-102009 044 240
- FR-A1- 2 886 477
- US-A1- 2006 175 906

## Description

La présente invention concerne d'une manière générale le domaine des machines électriques tournantes notamment pour véhicule automobile.

Elle s'applique plus particulièrement aux alternateurs à redressement synchrone équipé de modules électroniques de puissance, et encore plus particulièrement aux alternateurs polyphasés.

Pour fixer les idées, on se placera dans ce qui suit dans le cas de l'application préférée de l'invention et il sera supposé que l'alternateur est du type triphasé, sans que cela limite en quoi que ce soit la portée de l'invention.

A titre d'exemple, le brevet français FR2886477B1 décrit une machine électrique tournante de type alterno-démarreur comportant des moyens électroniques de puissance. Ces moyens électroniques de puissance se présentent sous la forme de modules de type dit mécatronique incluant un pont de transistors de puissance en technologie MOSFET et assurent une fonction réversible de convertisseur analogique-continu de puissance ("AC/DC" selon la terminologie anglo-saxonne couramment utilisée).

Dans le mode de fonctionnement en alternateur de la machine électrique tournante, le convertisseur précité assure le redressement des tensions alternatives de phase produites par l'alternateur en une tension continue unique d'alimentation (typiquement 14 Volts) qui alimente un réseau d'alimentation de bord du véhicule automobile. Inversement, comme il est bien connu de l'homme de métier, dans le mode de fonctionnement en moteur/démarreur de la machine électrique tournante, le convertisseur fournit des tensions de phase qui alimentent des bobinages statoriques de la machine électrique tournante. Une rotation du rotor de la machine électrique tournante dotée d'un couple mécanique suffisant est ainsi provoquée, ce de manière à assurer le démarrage du moteur thermique du véhicule. Les tensions de phase fournies sont obtenues par découpage, au moyen du pont de transistors de puissance, de la tension continue du réseau d'alimentation de bord (tension continue fournie par une batterie de stockage d'énergie).

Les moyens électroniques de puissance décrit dans le brevet français précité FR2886477B1 comportent trois modules identiques, un par branche de pont et un module de commande intégrant un circuit intégré spécialisé connu sous l'acronyme "ASIC" (pour "Application-Specific Integrated Circuit" selon la terminologie anglo-saxonne couramment utilisée) Les modules de branche de pont forment chacun une branche du pont de transistors.

L'architecture du module de branche de pont selon ce brevet est décrite, par exemple, par référence aux Fig.4A à 4E. Des transistors MOSFET, sous forme de puces électroniques nues, sont brasés sur des grilles de connexion, dites "leadframes" selon la terminologie anglo-saxonne couramment utilisée, qui sont surmoulées dans un boîtier mécatronique. Ces grilles de connexion sont maintenues plaquées sur une semelle métallique par l'intermédiaire d'une plaquette électriquement isolante qui est disposée en sandwich entre les grilles de connexion et la semelle. La plaquette possède des propriétés de bonne conduction thermique de manière à transmettre les calories générées par les puces électroniques vers un dissipateur thermique placé sous la semelle métallique du module.

La technologie divulguée par le brevet français FR2886477B1 trouve diverses applications dans les machines électriques tournantes et donne en particulier de très bons résultats, en termes de qualité et de performances, dans les applications de type alterno-démarreur qui nécessitent un pont de redressement réversible.

Cependant, comme il vient de l'être rappelé, les modules de puissance nécessitent une semelle conductrice de la chaleur qui, en réalité, joue un rôle de dissipateur intermédiaire puisque l'agencement décrit ne permet pas de plaquer directement la puce semi-conductrice sur le dissipateur principal. En outre, le flux calorique doit traverser la plaquette isolante. Même si cette dernière est choisie bonne conductrice de la chaleur, cette solution n'est pas optimisée. D'autres solutions on été proposées dans l'art, notamment dans les brevets DE 10 2009 044 240 A1 et US 2006/0175906 A1.

Enfin, comme il a été également rappelé, il est nécessaire de conditionner les puces électroniques dans un boîtier en technologie dite mécatronique.

Ces dispositions augmentent la complexité et le nombre de pièces mécaniques utilisées, et de ce fait notamment le prix de revient.

L'invention, tout en conservant les avantages des dispositifs de l'Art Connu, notamment celles décrites dans le brevet français FR-28864 7781, vise à en pallier les inconvénients, dont certains viennent d'être rappelés.

L'invention se fixe pour but une architecture de modules électroniques de puissance interconnectés pour une machine électrique tournante polyphasée telle que définie par la revendication 1.

Pour ce faire, selon une première caractéristique importante, les modules de puissances sont implémentés directement dans un dissipateur thermique.

Dans une forme de réalisation particulière, les modules de puissance comprennent chacun les circuits électroniques de puissance de deux branches de pont de redressement synchrone et des circuits de commande des circuits électroniques de puissance.

De façon préférentielle, les circuits de puissance sont réalisés à base de transistor MOSFET. Les circuits de commandes sont réalisés de préférence en technologie dite "ASIC" (acronyme de l'expression anglo-saxonne couramment utilisée "Application Specific Integrated Circuits" ou circuits intégrés pour applications spécifiques). Les modules de puissance comprenant les circuits électroniques de puissance proprement dits et les circuits de commandes présentent sous la forme de substrats en technologie dite "DBC" (acronyme de l'expression anglo-saxonne couramment utilisée "Direct Bonded Copper" ou cuivre directement collé) qui présente de nombreux avantages, notamment une bonne conductivité thermique. Le substrat est constitué de trois couches comprenant un couche inférieure en cuivre ou en aluminium, une couche isolante médiane en céramique (alumine, oxyde de béryllium, etc.) et une couche supérieure en matériau conducteur, généralement du cuivre. Cette couche est subdivisée en une pluralité de traces conductrices, les composants électroniques du module de puissance étant brasés à ces traces. Cette technologie est bien connue de l'Homme de Métier et il est inutile de la détaillée plus avant.

Selon une autre caractéristique importante de l'invention, le dissipateur thermique comporte des cavités ouvertes sur une de ses faces destinées à recevoir chacune un desdits modules de puissance.

Selon une autre caractéristique importante de l'invention encore, les modules de puissance sont collés directement sur le fond des cavités du dissipateur. De façon préférentielle, après assemblage, ces cavités sont remplies de gel de façon à recouvrir et isoler les modules de puissance.

Selon une autre caractéristique importante de l'invention encore, les interconnexions entre, les bornes des bobinages de phase de la machine tournante, les bornes de la source d'énergie électrique continue du véhicule (généralement une borne positive dite B+ et la masse) et les bornes puissance des branches du pont redresseur et de signal des circuits de commande sont réalisées par l'intermédiaire, d'une part, de premiers moyens comprenant une plaque en matériau isolant, par exemple du plastique, comportant une pluralité de traces conductrices, par exemple en cuivre, et, d'autre part, une pluralité d'éléments de connexion d'entrée-sortie avec les circuits électroniques des substrats précités, de type languettes, clous, plots ou pins, préalablement brasés sur ces substrats.

Selon une autre caractéristique importante de l'invention encore, les connexions électriques entre les dits éléments de connexion d'entrée-sortie des circuits électroniques sont réalisés par soudure de type électrique ou laser, selon diverses configuration mécaniques et géométriques qui seront détaillés dans ce qui suit.

L'invention a donc pour objet principal une architecture de modules électroniques de puissance interconnectés pour une machine tournante polyphasée caractérisée en ce qu'elle comprend au moins deux modules de puissance interconnectés électriquement, en ce qu'elle comprend un connecteur comportant au moins une couche constituée d'une pluralité de traces conductrices portée par au moins une plaque en matériau isolant pour interconnecter entre eux lesdits modules de puissance, d'une part, et lesdits modules de puissance à des éléments électriques de ladite machine tournante, d'autre part, en ce que lesdits modules de puissance comportent une pluralité d'éléments de connexion connectés électriquement, en une première extrémité, à des composants desdits modules de puissance et, en une seconde extrémité, à l'une desdites traces conductrices du connecteur, en ce qu'elle comprend en outre un dissipateur thermique muni de cavités ouvertes destinées à recevoir, chacune, l'un desdits modules de puissance.

L'invention a encore pour objet une machine tournante polyphasée comprenant une telle architecture de modules électroniques de puissance interconnectés.

L'invention va maintenant être décrite de façon plus détaillée en se référant aux dessins annexés, parmi lesquels :
- la figure 1 illustre schématiquement, en coupe longitudinale, un exemple de structure d'une machine électrique tournante selon l'Art Connu;
- la figure 2 illustre schématiquement un exemple de circuit de redressement de tension de type à redressement synchrone;
- la figure 3 illustre dans l'espace et en éclaté les principaux sous-ensembles d'un exemple d'architecture préférée de modules de puissances et de leurs interconnexions pour la mise en œuvre du procédé d'interconnexion de modules de puissance selon l'invention :
- la figure 4 illustre schématiquement le montage des modules de puissance dans les cavités du dissipateur représenté sur la figure 3;
- la figure 4A est une vue de détail d'un élément de connexion représenté sur la figure 4;
- la figure 5 est une vue partielle du dissipateur et d'un module de puissance représentés sur la figure 4 illustrant un autre mode de réalisation des éléments de connexion; et
- les figures 6A à 6D illustrent quatre modes de réalisation selon l'invention d'éléments de connexion des modules de puissance à un connecteur d'interconnexion et les procédés de soudure mis en œuvre dans ces modes de réalisation.

Dans ce qui suit, sans en limiter en quoi que ce soit la portée, on se placera ci-après dans le cadre de l'application préférée de l'invention, sauf mention contraire, c'est-à-dire dans le cas d'un alternateur à redressement synchrone du type double triphasé comprenant trois modules de puissance comportant chacun les circuits électroniques de puissance de deux branches de pont de redressement et des circuits de commande de ces circuits électroniques de puissance.

Toujours dans ce qui suit, les éléments identiques ou pour le moins similaires sur les figures portent les mêmes références et ne seront re-décrits qu'en tant que de besoin.

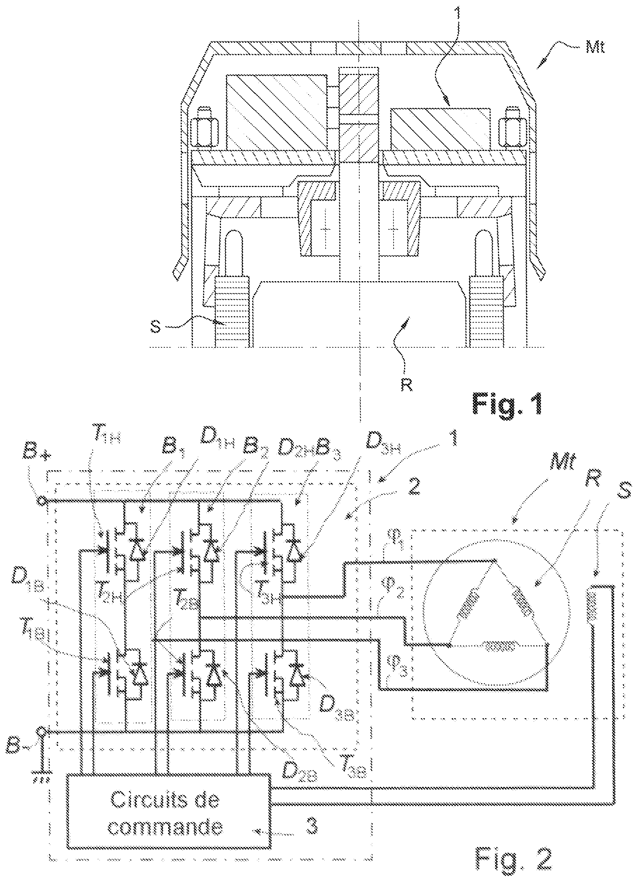

Avant de décrire l'invention, il est utile de rappeler brièvement la structure générale d'une machine de ce type et un exemple de circuits électroniques de puissance du pont de redressement et de circuit électronique de commande de ces circuits, par référence aux figures 1 et 2.

La figure 1 illustre très schématiquement, en coupe longitudinale, un exemple de structure d'une machine électrique tournante *Mt* selon l'Art Connu, à savoir ici, un alternateur triphasé à redressement synchrone. Celui-ci comprend, de manière classique, un stator *S* et un rotor *R*, ainsi qu'un module électronique de puissance, regroupant des circuits électroniques de puissance proprement dits (pont de redressement) et des circuits de commande de ces circuits de puissance.

La figure 2 illustre un exemple de configuration de circuits électriques et électroniques pouvant être mis en œuvre dans l'alternateur triphasé *Mt* de la figure 1.

Comme illustré par la figure 2, l'alterno-démarreur *Mt* est associé à des circuits électroniques de puissance et de commande sous la référence générale 1. Ces circuits comprennent un pont synchrone de de redressement de tension 2 et un régulateur de tension 3. Le rotor *R* est entraîné en rotation par une courroie de transmission le reliant au vilebrequin du moteur thermique 5 du véhicule (non illustrés sur la figure 1).

Dans cette forme de réalisation, l'alternateur *Mt* est une machine triphasée de type Lundell.

La figure 2 illustre schématiquement un exemple de circuit de redressement de tension 2 de type à redressement synchrone. Celui-ci comprend essentiellement un pont de redressement de tension constitué de trois branches, *B*₁ à *B*₃, et des circuits de commande 3 du pont 2.

Dans l'exemple décrit, chaque branche, *B*₁ à *B*₃, du pont 2 comprend deux transistors de puissance en cascade de type MOSFET, *T*_{1H}-*T*_{1B}, *T*_{2H}-*T*_{2B}, *T*_{3H}-*T*_{3B}, respectivement. Les signes *H* et *B* signifient arbitrairement haut et bas de branche, respectivement. Les extrémités hautes des branches, *B*₁ à *B*₃, sont reliées à la borne *B*+ et les extrémités basses à la borne *B*- (généralement reliée à la masse) d'un organe de stockage d'énergie électrique continue (batterie du véhicule, non illustrée sur la figure 2). De façon classique en soi, des diodes antiparallèles, *D*_{1H} à *D*_{3B}, sont branchées aux bornes source et drain des transistors MOSFET, *T*_{1H} à *T*_{3B}.

Les branches *B*₁ à *B*₃, sont connectées en leurs points milieux aux trois sorties de phase, ϕ₁ à ϕ₃, des bobinages du stator *S*.

Les circuits de commande 3 délivrent aux grilles des transistors MOSFET, *T*_{1H} à *T*_{3B}, des signaux de commande, *CG*_{1H} à *CG*_{3B}, respectivement.

Les circuits de commande 2 comprennent des circuits de mise en forme des signaux de commande de grille (non explicitement illustrés sur la figure 2) qui réalisent une mise en forme adaptée des signaux, *CG*_{1H} à *CG*_{3B}, de manière à obtenir un fonctionnement en redressement synchrone des transistors MOSFET, *T*_{1H}-*T*_{1B}, du pont 2. Ce type de fonctionnement en redressement synchrone des transistors MOSFET, *T*_{1H}-*T*_{1B}, est bien connu de l'Homme de Métier et il est inutile de le décrire plus avant.

Les circuits de commande 2 comprennent également des circuits de régulation (non explicitement illustrés sur la figure 2), de façon à délivrer une tension continue de précision prédéterminée entre les bornes *B*+ et *B*-, classiquement +12 V. Ce type de circuits est également bien connu de l'Homme de Métier et il est inutile de le décrire plus avant.

De même, ces circuits de commande 3 délivrent un courant d'excitation de l'enroulement du stator S.

Enfin, les circuits de commande 3 peuvent comprendre des circuits de détection d'erreurs et/ou de dysfonctionnement du pont de redressement 2, notamment pour protéger les transistors MOSFET, T1H-T1B, en cas de détection de surcharge.

Dans l'Art Connu, notamment celui décrit par le brevet FR2886477B1, le pont 2 est, en réalité, divisé en trois parties correspondant aux trois branches de pont, *B*₁ à *B*₃. Chaque branche, B1 à B3, se présente sous la forme d'un substrat encapsulé dans un boîtier dit mécatronique indépendant et les circuits de commande sont réalisés sous la forme d'un circuit intégré "ASIC", l'ensemble étant complété par des moyens d'interconnexion électrique et de fixation mécanique. Comme il a été indiqué dans le préambule de l'invention, cette architecture présente un certain nombre d'inconvénients qu'il est inutile de rappeler ici.

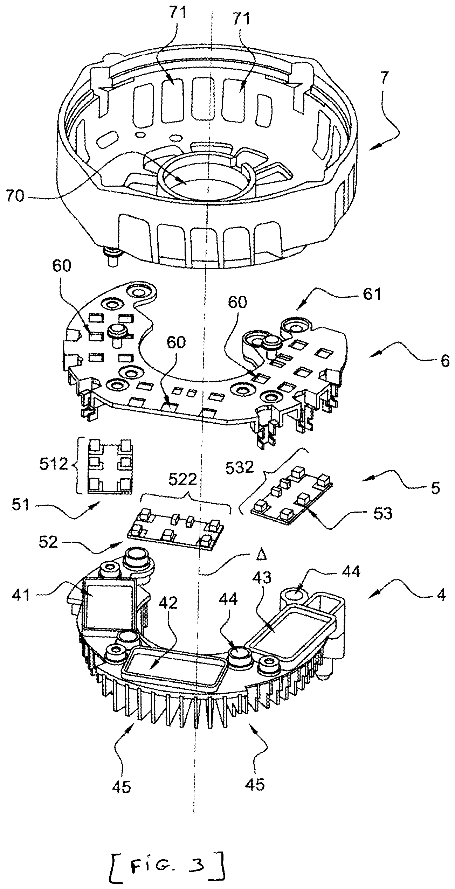

Dans la présente invention, tout en conservant la structure générale d'une machine tournante de l'Art Connu et la configuration des circuits électroniques en tant que telle, ce qui représente un avantage certain, on prévoit une partition et une implémentation physique de ces circuits qui évitent les inconvénients précités et permet d'atteindre les buts visés, comme il va maintenant l'être montré en relation avec les figures 3 à 6D.

La figure 3 illustre dans l'espace et en éclaté autour d'un axe de symétrie longitudinal Δ, les principaux sous-ensembles d'un exemple d'architecture préférée de modules de puissance dans laquelle va être mis en œuvre du procédé d'interconnexion selon l'invention.

L'architecture illustrée sur cette figure concerne un alternateur de type double triphasé et comprend trois sous-ensembles propres à l'invention : un dissipateur thermique 4, une série de modules de puissance 5, référencés 51 à 53, et des moyens 6 d'interconnexion électrique entre la série de modules 5. Les modules de puissance 5 de la série comporte chacun les circuits électroniques de deux branches de pont de redressement et les circuits de commande correspondants.

Selon une caractéristique importante de l'invention, le dissipateur thermique 4 est muni sur sa face supérieure (sur la figure 3), sensiblement plane, de trois cavités ouvertes, 41 à 43, à fond plat, destinées à recevoir les modules, 51 à 53. La face inférieure du dissipateur 4 est munie, de façon classique, d'ailettes 45 ou d'organes similaires destinées à améliorer les échanges thermiques avec l'air ambiant.

Le dissipateur thermique 4 a la forme générale d'un "fer à cheval" (arc de cercle) de façon à laisser un libre passage à l'air dans sa partie centrale, ce dans un but de refroidissement des organes internes de la machine tournante (bobinages, etc.), dont seule la partie mécanique supérieure 7 (palier arrière) a été représentée sur la figure 3. De façon habituelle, l'air ambiant est aspiré vers l'intérieur de la machine tournante par un ventilateur tournant avec le rotor (non représentés sur la figure 3). La pièce 7 comporte une pluralité d'orifices (non repérés) entourant un orifice central 70 destiné à recevoir une capsule de roulement, et des orifices latéraux 71 laissant entrer l'air à l'intérieur de la machine tournante.

De façon classique en soi, après assemblage final, les trois sous-ensembles, 4 à 6, sont assujettis mécaniquement à la pièce mécanique 7 par tous moyens appropriés (vis, etc.), le "fer à cheval" couvrant partiellement la périphérie.

Chaque module, 51 à 53, comprend un substrat regroupant des circuits électroniques de puissance proprement dits (les transistors MOSFET de deux branches du pont de redressement hexaphasé) et des circuits de commande de ce pont.

Selon une autre caractéristique de l'invention, les circuits de commande sont répartis dans les trois modules, 51 à 53, et non pas centralisés comme pour l'exemple d'alternateur triphasé de la figure 2. Ils se présentent sous la forme de circuits intégrés réalisés préférentiellement en technologie "ASIC".

En dehors de ces particularités, les schémas fonctionnels des circuits de puissance et de commande mis en œuvre dans l'art connu peuvent être conservés dans le cadre de l'invention, ce qui représente un avantage supplémentaire comme déjà signalé, puisqu'une nouvelle conception fonctionnelle de ces circuits n'est pas nécessaire.

Les circuits de puissance et de commande sont disposés sur un substrat, le tout réalisé préférentiellement en technologie "DBC" et constituant les modules de puissance précités, 51 à 53.

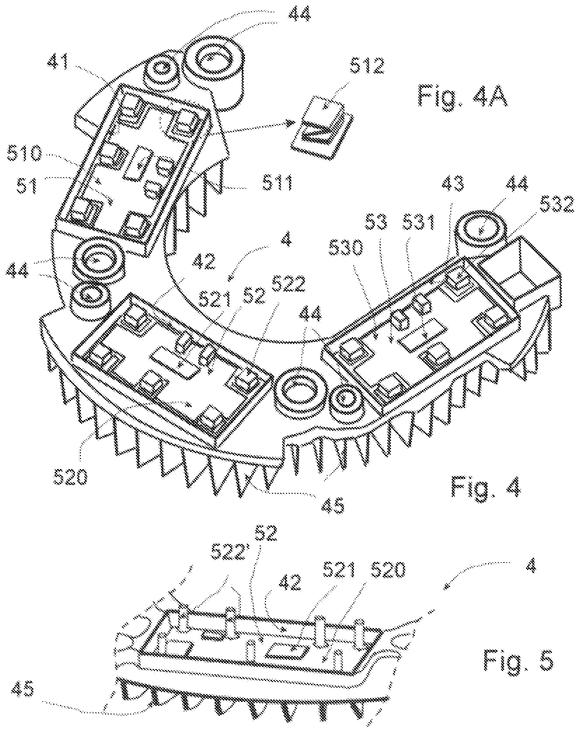

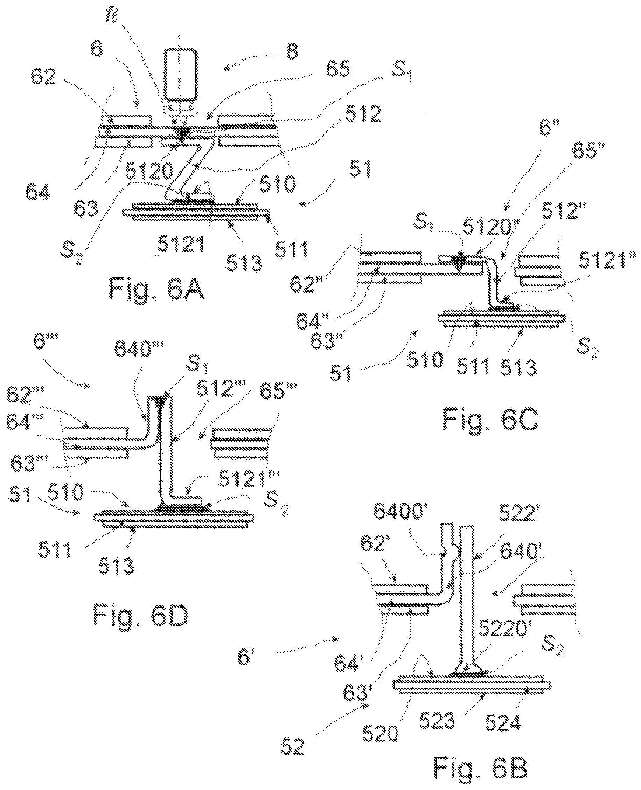

Les substrats des modules, 51 à 53, seront précisés ci-après par référence à la figure 4. Des éléments de connexion (figure 3 : sous les références générales 512, 522 et 532), susceptibles de prendre diverses configurations (qui seront décrites de façon détaillée par référence aux figures 6A à 6D), sont brasés ou soudés par ultrasons directement sur les substrats des modules, 51 à 53, conformément à une des caractéristiques importantes du procédé d'interconnexion de modules de puissance selon l'invention. Ils permettent d'établir des connexions électriques avec les moyens d'interconnexion 6 entre modules 5.

Les moyens d'interconnexion 6 se présentent sous la forme générale d'une platine constituant un connecteur électrique plan. Cette platine comprend une ou plusieurs couches planes en matériau isolant, par exemple du plastique de type PPS. Cette platine supporte une pluralité de pistes ou traces conductrices, par exemple en cuivre ou tout autre métal approprié, véhiculant, d'une part, des courants électriques dits "forts" (liaisons avec les bornes *B*+ et *B*- de la batterie, les bornes des branches du pont de redressement, réparties dans les modules, 51 à 53, et les bornes des bobinages de la machine tournante), et, d'autre part, courants dits "faibles" (signaux de commande). Les traces conductrices peuvent être surmoulées et disposées en sandwich entre des couches de matériau isolant de la platine 6.

Chaque élément de connexion précité, brasés sur les substrats des modules, 51 à 53, est connecté électriquement à une ou plusieurs traces conductrices de façon à former un réseau d'interconnexions de configuration prédéterminée reliant les modules, 51 à 53, entre eux et un régulateur de tension présent également dans l'alternateur, d'une part et, d'autre part, ces modules, 51 à 53, aux bornes de phases et de tension redressée de sortie (borne B+ et de masse) de l'alternateur. Pour ce faire, la platine 6 formant connecteur présente une géométrie semblable de celle du dissipateur thermique 4 (forme en "fer à cheval"), de façon à pouvoir la fixer mécaniquement sur celui-ci, après assemblage des modules, 51 à 53, dans les cavités, 41 à 43.

La platine 6 comporte en outre des zones, sous la référence générale 60, laissant libre accès aux traces conductrices dont les dimensions et la répartition spatiale sont en adéquation avec celles des éléments de connexion, 512, 522 et 532, brasés sur les substrats des modules, 51 à 53.

L'assujettissement mécanique des deux sous-ensembles : dissipateur thermique 4 et connecteur 6 s'effectue par tous moyens classique bien connu de l'Homme de Métier (vissage, etc.). Pour fixer les idées, sur la figure 3, on a représenté, de façon schématique, des moyens de fixation sous les références générales 44 (dissipateur thermique 4) et 61 (connecteur 6). En outre, comme déjà signalé, cet assemblage est aussi fixé mécaniquement à la pièce 7 par tous moyens conventionnels (non représentés sur la figure 3).

La figure 4 illustre schématiquement, en vue de haut dans l'espace, le montage des modules 51 à 53 dans les cavités 41 à 43 du dissipateur 4.

Les modules, 51 à 53, comprennent des substrats dont seules les couches supérieures ont été référencées, 510 à 530. Ces substrats sont préférentiellement réalisés en technologie "DBC". On a également représenté sur la figure 4 des circuits intégrés 511 à 531 portés par les substrats. Dans cette forme de réalisation de l'invention, un seul circuit de commande 511, 521 ou 531 est prévu par module, 51 à 530. Cependant, on doit bien comprendre que ceux-ci peuvent comprendre plusieurs circuits intégrés : notamment les circuits de commande de pont, préférentiellement réalisés en technologie "ASIC" et les transistors MOSFETS. Enfin, on a représenté schématiquement, des éléments de connexion. Ces éléments de connexion sont directement brasés sur plages conductrices et/ou sur les circuits intégrés des modules, 51 à 53, et sont destinés à établir des contacts galvaniques avec les traces conductrices du connecteur 6 (figure 3).

Les configurations géométriques et les modes de réalisation de ces éléments seront précisés ci-après par référence aux figures 6A à 6D.

Un seul élément de connexion a été expressément référencé sur la figure 4 : l'élément de connexion 512 du module 51, illustré de façon plus détaillé par la figure 4A. L'élément 512 a la forme générale d'une languette en matériau conducteur repliée en "Z", ayant une face plane inférieure en contact électrique avec le substrat des modules, 51 à 53, et une face plane supérieure destinée à être mise en contact électrique avec une des traces du connecteur 6 (figure 3). Ce mode de réalisation correspond à celui qui sera explicité en regard de la figure 6A.

La figure 5 illustre un autre mode de réalisation d'éléments de connexion, sous la forme de plots cylindriques verticaux, du type queue de diode semi-conductrice ou de composants similaires (résistance, etc.). Sur la figure 5, seule la partie centrale du dissipateur thermique 4 a été représentée, c'est-à-dire celle correspondant à la cavité 42 et au module 52. A l'exception du mode de réalisation de l'élément de connexion 522', les autres éléments de la figure 5 sont identiques à ceux de la figure 4 et il est inutile de les re-décrire. Ce mode de réalisation d'élément de connexion correspond à celui qui sera explicité plus particulièrement en regard de la figure 6B, mais il peut être mis en œuvre aussi pour ceux correspondant à ceux qui seront explicités en regard des figures 6C et 6D.

Quel que soit le mode de réalisation des éléments de connexion retenu, la fixation des modules, 51 à 53, dans les cavités, 41 à 43, est obtenu par collage sur le fond de ces cavités, directement sur le dissipateur 4, c'est-à-dire sans éléments intermédiaires contrairement à l'art connu décrit par le brevet français FR2886477B1. Pour fixer les idées, une colle du type colle thermique silicone peut être utilisée à cette fin. Après assemblage des modules, 51 à 53, dans les cavités, 41 à 43, ces dernières peuvent être remplies d'un gel tel par exemple qu'un gel silicone bi-composant, ce qui permet d'isoler électriquement les composants semi-conducteurs et de réaliser une protection mécanique.

Pour fixer les idées et sans que cela limite en quoi que ce soit la portée de l'invention, on va maintenant décrire, par référence aux figures 6A à 6D, quatre modes de réalisation principaux d'éléments de connexion, ainsi que la manière de connecter ces éléments de connexion aux traces conductrices du connecteur 6 (figure 3).

La figure 6A illustre schématiquement un élément de connexion 512 constitué d'une languette plate en matériau conducteur, pliée en accordéon pour prendre la forme générale d'un "Z". Ce mode de réalisation correspond à celui qui a été illustré par la figure 4.

On a représenté schématiquement sur la figure 6A le substrat du module 51 et on a supposé qu'il comprenait une plaque de matériau isolant 511, en sandwich entre une plaque sous-jacente de matériau conducteur 513 et des plages conductrices 510 courant sur la face supérieure. La configuration est identique pour les autres substrats, 52 ou 53

Chaque élément de connexion 512 est brasé (par la branche inférieure 5121 du "Z") sur une plage conductrice 510, ou à titre d'alternative sur un élément semi-conducteur (MOSFET du pont de redressement non représenté sur la figure 6A) : soudure *S*₂. La couche supérieure 510 est constituée d'une pluralité de traces d'interconnexions entre des bornes d'entrée et/ou sorties des composants du module de puissance (51 dans l'exemple de la figure 6A) soudés sur cette couche.

On a également représenté sur la figure 6A une portion du connecteur 6 disposé en surplomb du module 51 et de l'élément de connexion 512. On a supposé, dans l'exemple décrit, que le connecteur 6 comportait une seule couche 64 de traces en matériau conducteur, disposée en sandwich entre deux plaques de matériau isolant, supérieure 62 et inférieure 63. Naturellement, on doit bien comprendre que l'invention n'est pas limitée à une seule couche de traces conductrices. On peut en effet prévoir, dans une variante de réalisation non représentée, plusieurs couches de traces conductrices superposées séparées par des plaques de matériau isolant.

On prévoit des évidements 65 dans les zones des plaques isolantes, 62 et 63, surplombant les banches supérieures 5120 des éléments de connexion 512.

Selon ce mode de réalisation, de par leur forme en "Z" et les propriétés élastiques du matériau constituant la languette, les éléments de connexion 512 sont dotés d'une fonction "ressort", ce qui permet d'assurer un bon contact mécanique en exerçant une force d'appui lors de la mise en place du connecteur 6.

Les traces 64 du connecteur 6 sont soudées sur l'élément de connexion 512 (sur la branche supérieure 5120 du "Z") par soudure laser par transparence, c'est-à-dire au travers de la trace conductrice 64 : soudure *S*₁. Le laser 8 permettant cette opération est illustré schématiquement sur la figure 6A, ainsi que le faisceau émis *fl* convergeant sur la branche supérieure 5120 du "Z".

Une soudure laser présente l'avantage d'exiger moins d'énergie que la soudure par résistance. Il y a donc moins de risques d'endommager les brasures sur les substrats et les composants semi-conducteurs (MOSFETS).

Pour fixer les idées, les caractéristiques du procédé de réalisation des connexions électriques sont typiquement les suivantes :
- Idéalement, l'épaisseur de la trace 63 à traverser ne doit pas dépasser 0,6 mm;
- L'épaisseur de la trace située en dessous (c'est-à-dire la branche supérieure 5120 du "Z") doit être au moins égale à l'épaisseur de la trace traversée 64;
- Le jeu maximum admissible entre les traces, 64 et 5120, pour une soudure traversante est d'environ 20% de l'épaisseur traversée soit 0,12 mm dans l'exemple retenu;
- Un effort de pression sur le connecteur 6 est nécessaire et doit être calculé pour ne pas endommager le substrat 52 et ses composants;
- Pour obtenir une bonne soudure laser par transparence, la trace du dessus 64 doit subir un traitement de surface mat du type nickelage pour limiter la réflexion du faisceau laser (par exemple, en mettant en œuvre la technologie de nickelage dite « sulfamat » - marque déposée). Par contre l'étain et le phosphore ne sont pas acceptables car ils risquent de créer des fissures dans la soudure.

La figure 6B illustre schématiquement un élément de connexion 522' constitué d'un plot cylindrique en matériau conducteur perpendiculaire au plan de la couche supérieure 520 du substrat 52 (ou des autres substrats, 51 ou 53). Le plot 522' comportent une embase de plus grand diamètre brasée directement (soudure *S*₂) sur la couche supérieure 520 du substrat sous-jacent 52 (ou en alternative sur un composant de puissance : MOSFET, non représenté). La couche supérieure 520 est constituée d'une pluralité de traces d'interconnexions entre des bornes d'entrée et/ou sorties des composants du module de puissance (52 dans l'exemple de la figure 6B) soudés sur cette couche. Ce mode de réalisation correspond à celui qui a été illustré par la figure 5.

Selon ce mode de réalisation et dans l'exemple décrit sur la figure 6B, le connecteur, désormais référencé 6', est supposé comporter, comme dans l'exemple de la figure 6A, une seule couche de traces conductrices 64', en sandwich entre deux plaques de matériau isolant, 62' et 63'. Par contre, toujours dans ce mode de réalisation, il est nécessaire que la trace conductrice 64', et non seulement les plaques isolantes, 62' et 63', soit également munie d'une alvéole, 65', pour laisser le libre passage à l'extrémité supérieure de l'élément de connexion 522' au travers de l'empilement de couches 62'-64'-63'. Une des extrémités, 640', de de la trace conductrice 64' se prolonge dans la zone d'évidement 65'. Elle est repliée à 90° vers le haut. Cette dernière comporte un embouti 6400' destinée à être mis en contact avec l'élément de connexion 522' dans sa partie supérieure.

Dans ce mode de réalisation, la soudure entre la trace 64' et l'élément de connexion est réalisé par un procédé de soudure par résistance au niveau de l'embouti 6400'. Il s'agit d'un procédé bien connu de l'Homme de Métier. Il est couramment utilisé, notamment utilisé pour souder des queues de diodes semi-conductrices ou des composants équivalents.

Pour fixer les idées, selon cette variante, les caractéristiques du procédé de réalisation des connexions électriques sont typiquement les suivantes :
- le procédé de soudure par résistance est bien maîtrisé et ne pose pas de problème particulier si les éléments à souder (plots 522' et trace 64') ont des dimensions semblables à celles de diodes semi-conductrices précitées;
- typiquement, les plots 522' ont un diamètre de 1,2 mm;
- en variante, au lieu d'être cylindriques, les plots 522' peuvent être dotés d'une section carrée ou rectangulaire si la languette repliée 640' de la trace 64' comporte un picot embouti;
- des paramètres typiques de la soudure sont les suivants : effort de 35 DaN, courant électrique d'environ 8000 A sous 2 V durant un lapse de temps de 20 à 30 ms. Les électrodes doivent descendre jusqu'à 1,5 mm minimum sous le bossage 6400' de la trace 64'.

La figure 6C illustre une variante supplémentaire de réalisation des éléments de connexion, désormais référencés 512".

Comme précédemment, l'élément de connexion 512" est constitué par un plot cylindrique en matériau conducteur, perpendiculaire au plan de la couche supérieure 510 du substrat 51 (ou des autres substrats, 52 ou 53). L'embase 5121" de celui-ci, qui peut être constituée d'un repli à 90°, est brasée (soudure *S*₂) sur la couche supérieure 510 du substrat sous-jacent 51 (ou en alternative sur un composant de puissance : MOSFET, non représenté sur la figure 6C).

On a supposé, comme précédemment que la trace conductrice 64" était unique et prise en sandwich entre deux plaques en matériau isolant, 62" et 63". Comme précédemment également, cette trace conductrice 64" est percée d'un orifice 65", se prolonge dans la zone d'évidement tout en laissant passer l'extrémité du plot 512". La partie supérieure 5120" de l'élément du plot 512" est repliée à 90°, de façon à venir en contact avec la face supérieure de l'extrémité de la trace conductrice 64".

Comme dans le mode de réalisation de connexion décrit en regard de la figure 6A, la soudure est du type soudure laser par transparence et en présente les avantages qui ont été rappelés. C'est donc la partie repliée 5120" du plot qui est traversé par le faisceau laser (non explicitement représentés sur la figure 6C) et soudée à la trace conductrice 64" : soudure *S*₁.

Pour fixer les idées, les caractéristiques du procédé de réalisation des connexions électriques sont typiquement les suivantes :
- La trace à traverser par le faisceau laser, c'est-à-dire la partie repliée 5120" du plot 512", peut être plus fine, avec une épaisseur qui peut descendre jusqu'à 0,3 mm ce qui permet;
- une énergie nécessaire pour souder plus faible;
- une épaisseur de trace conductrice 64" de 0,8 mm à 1 mm pour passer le courant;
- aucune nécessité de recourir à un nickelage des traces 64" du connecteur 6";
- le contact entre traces 64" et plots 512" est assuré simplement par l'opération de pliage.

La figure 6D illustre une variante supplémentaire de réalisation de l'élément de connexion, désormais référencé 512"'. Ce dernier est semblable à l'élément de connexion 512" quant à sa configuration spatiale, mais de section rectangulaire ou carrée, et non plié dans sa partie supérieure. Son embase 5121"', qui peut être repliée à l'horizontal, est brasée (soudure *S*₂) sur la couche supérieure 510 du substrat sous-jacent 51 (ou en alternative sur un composant de puissance : MOSFET, non représenté).

Comme précédemment, on a supposé que le connecteur 6'" ne comportait qu'une seule couche de traces conductrices 64"', en sandwich entre deux plaques isolantes, 62'" et 63"'.

Il est également nécessaire de prévoir une ouverture totale 65'" dans les plaques isolantes, 62'" et 63"', et dans la trace conductrice 64"', de façon à laisser passer l'extrémité supérieure du plot 512"', d'une part, et, d'autre part, une extrémité de trace 640'" repliée à 90° vers le haut et mise en contact avec l'extrémité supérieure du plot 64"'.

La soudure est également effectuée selon le procédé laser par transparence à l'aide d'un laser semblable à celui représenté sur la figure 6A. La disposition relative des deux éléments permet d'effectuer une soudure laser (soudure *S*₁) à bords relevés sur les extrémités respectives de la trace conductrice 64'" et du plot 512"'.

Pour fixer les idées, les caractéristiques du procédé de réalisation des connexions électriques selon cette variante sont typiquement les suivantes :
- Cette solution nécessite un outillage pour plaquer la trace conductrice 64'" contre le plot 512'" car le jeu maximum pour souder correctement ces éléments ne doit pas dépasser 5% des épaisseurs des éléments en contact;
- Le laser doit être équipé d'un système de recalage vision ou doit être monté sur l'outil de plaquage précité pour assurer une soudure correcte à la jonction de la trace conductrice 64'" et du plot 512'";
- Un nickelage est possible sur l'une ou l'autre des surfaces d'éléments à souder, voire sur les deux, mais n'est plus nécessaire;
- Pour une trace 64'" du connecteur 6 de 0,8 mm d'épaisseur, il est nécessaire que l'élément de connexion brasé 5121'" ait une épaisseur de 0,4 mm minimum et préférentiellement que son épaisseur soit identique à celle de la trace conductrice 64'" en son extrémité 640"'.

A la lecture de ce qui précède, on constate aisément que l'invention atteint bien les buts qu'elle s'est fixée, et qu'il est inutile de rappeler entièrement.

Toutefois, l'invention n'est pas limitée aux seuls dispositifs conformes aux seuls modes de réalisation explicitement décrits en regard des figures 3 à 6D. De même, l'architecture de modules électroniques de puissance interconnectés conforme aux dispositifs décrits ne s'applique pas seulement à un alternateur à pont de redressement synchrone, qui en constitue l'application préférée, mais de façon plus générale, à toute machine électrique tournante polyphasée comportant au moins deux modules de puissance à interconnecter via des éléments de connexion dont l'une des extrémités est brasée ou soudée par ultrasons sur ces modules et l'autre soudée à une trace conductrice d'un connecteur comportant au moins une couche de traces conductrices portée par au moins une plaque isolante.

## Revendications

1. Architecture de modules électroniques de puissance interconnectés pour une machine tournante *(Mt)* polyphasée, comprenant au moins deux modules de puissance interconnectés électriquement (51 à 53), un connecteur (6) comportant au moins une couche constituée d'une pluralité de traces conductrices (64) de signal ou de puissance portée par au moins une plaque en matériau isolant (62, 63) pour interconnecter entre eux lesdits modules de puissance (51 à 53), d'une part, et lesdits modules de puissance (51 à 53) à des éléments électriques (phases ϕ, *B*+, *B*-) de ladite machine tournante *(Mt),* d'autre part, et un dissipateur thermique (4), ladite architecture étant **caractérisé en ce que** lesdits modules de puissance (51 à 53) comportent une pluralité d'éléments de connexion (512 à 532) connectés électriquement, en une première extrémité, à des composants (510 à 530) desdits modules de puissance et, en une seconde extrémité, à l'une desdites traces conductrices (64) du connecteur (6), **en ce que** le dissipateur thermique (4) est muni de cavités ouvertes (41 à 43) destinées à recevoir, chacune, l'un desdits modules de puissance (51 à 53), lesdits modules de puissance (51 à 53) comprennent, chacun, un substrat sur lequel sont implémentés des composants semi-conducteurs de puissance et des circuits intégrés électroniques de commande (3) de ces composants et **en ce que** chacun desdits substrats est collé sur la paroi de fond d'une desdites cavités ouvertes (41 à 43), lesdites cavités ouvertes (41 à 43) étant remplies de gel isolant après collage desdits substrat, **en ce que** ledit connecteur (6) comprend au moins une couche de traces conductrices (64) disposée en sandwich entre deux plaques en matériau isolant (62, 63) et **en ce que** lesdites traces conductrices (64) comprennent des liaisons à forte puissance véhiculant des courants dits "forts" pour interconnecter entre eux lesdits composants semi-conducteurs de puissance et des éléments électriques déterminés (phases ϕ, *B*+, *B*-) de ladite machine tournante (*Mt*) et des liaisons à faible puissance véhiculant des signaux de commande pour interconnecter lesdits circuits intégrés électroniques de commande (3), lesdits substrats étant réalisés selon la technologie de cuivre directement collé dite "DBC" et sont constitués d'au moins d'une couche inférieure (513) en matériau conducteur, d'une couche intermédiaire (511) en matériau isolant et d'une couche supérieure (510) constituée d'une pluralité de traces en matériau conducteur sur lesquels sont soudés lesdits composants semi-conducteurs de puissance et lesdits circuits intégrés électroniques de commande (3), et **en ce que** lesdits éléments de connexion (512 à 532) sont brasés sur lesdites traces de la couche supérieure (510) et/ou sur lesdits composants semi-conducteurs de puissance.

2. Architecture selon la revendication 1, **caractérisée en ce que** lesdits circuits intégrés électroniques de commande (3) sont réalisés sous la forme de circuits intégrés spécialisés selon la technologie dite "ASIC" implémentés sur lesdits substrats.

3. Architecture selon l'une quelconque des revendications 1 ou 2, **caractérisée en ce que**, ladite machine tournante *(Mt)* étant du type alternateur polyphasé comprenant un rotor (*R*) muni d'un enroulement pour chaque phase (ϕ), chaque enroulement générant un courant alternatif, lesdits composants semi-conducteurs de puissance de chacun desdits modules de puissance (51 à 53) constituent deux des branches (*B*) d'un pont de redressement polyphasé synchrone (2) et lesdits circuits intégrés électroniques de commande (3) sont des circuits répartis dans chacun desdits modules de puissance (51 à 53), de façon à générer des signaux de commande mis en forme pour chacun desdites branches de pont (*B*).

4. Architecture selon la revendication 3, **caractérisée en ce que** lesdits composants semi-conducteurs de puissance sont des transistors MOSFET.

5. Architecture selon l'une quelconques des revendications précédentes, **caractérisée en ce que** ledit connecteur (6) et ledit dissipateur thermique (4) sont fixés mécaniquement l'un à l'autre (44, 61).

6. Machine tournante polyphasée **caractérisée en ce qu'**elle comprend une architecture de modules électroniques de puissance interconnectés (51 à 53) selon l'une quelconque des revendications précédentes.

7. Machine tournante polyphasée selon la revendication précédente, **caractérisée en ce que** ledit connecteur (6) et ledit dissipateur thermique (4) sont fixés mécaniquement l'un à l'autre (44, 61) et à une partie mécanique supérieure (7) de ladite machine tournante *(Mt).*

8. Machine tournante polyphasée selon la revendication 7, **caractérisée en ce que** ladite partie mécanique supérieure (7) comporte des orifices aménagés autour d'une zone centrale (70) et laissant entrer l'air ambiant pour refroidir les organes internes à ladite machine tournante et **en ce que** ledit connecteur (6) et ledit dissipateur thermique (4) couvrent la surface périphérique de ladite partie mécanique supérieure (7) sur un arc de cercle, de façon à laisser libre passage dans ladite zone centrale au dit air ambiant.

## Patentansprüche

1. Architektur miteinander verbundener elektronischer Leistungsmodule für eine mehrphasige rotierende Maschine (*Mt*), welche wenigstens zwei elektrisch miteinander verbundene Leistungsmodule (51 bis 53), einen Verbinder (6), der wenigstens eine aus mehreren Signal- oder Leistungsleiterbahnen (64) bestehende Schicht aufweist, die von wenigstens einer Platte aus Isoliermaterial (62, 63) getragen wird, um einerseits die Leistungsmodule (51 bis 53) miteinander und andererseits die Leistungsmodule (51 bis 53) mit elektrischen Elementen (Phasen ϕ, *B*+, *B*-) der rotierenden Maschine (*Mt*) zu verbinden, und einen Kühlkörper (4) umfasst, wobei die Architektur **dadurch gekennzeichnet ist, dass** die Leistungsmodule (51 bis 53) mehrere Verbindungselemente (512 bis 532) aufweisen, die elektrisch an einem ersten Ende mit Komponenten (510 bis 530) der Leistungsmodule und an einem zweiten Ende mit einer der Leiterbahnen (64) des Verbinders (6) verbunden sind, dadurch, dass der Kühlkörper (4) mit offenen Vertiefungen (41 bis 43) versehen ist, die dazu bestimmt sind, jeweils eines der Leistungsmodule (51 bis 53) aufzunehmen, wobei die Leistungsmodule (51 bis 53) jeweils ein Substrat umfassen, auf welchem Leistungshalbleiterkomponenten und integrierte elektronische Steuerschaltungen (3) dieser Komponenten implementiert sind, und dadurch, dass jedes der Substrate auf die Bodenwand einer der offenen Vertiefungen (41 bis 43) geklebt ist, wobei die offenen Vertiefungen (41 bis 43) nach dem Kleben der Substrate mit Isoliergel gefüllt werden, dadurch, dass der Verbinder (6) wenigstens eine Schicht Leiterbahnen (64) umfasst, die sandwichartig zwischen zwei Platten aus Isoliermaterial (62, 63) angeordnet ist, und dadurch, dass die Leiterbahnen (64) Verbindungen für hohe Leistung, die sogenannte "starke" Ströme transportieren, um die Leistungshalbleiterkomponenten und bestimmte elektrische Elemente (Phasen ϕ, *B*+, *B*-) der rotierenden Maschine (Mt) miteinander zu verbinden, und Verbindungen für niedrige Leistung, die Steuersignale transportieren, um die integrierten elektronischen Steuerschaltungen (3) miteinander zu verbinden, umfassen, wobei die Substrate nach der sogenannten Direct Bonded Copper, DBC, Technologie hergestellt sind und aus wenigstens einer unteren Schicht (513) aus leitendem Material, einer Zwischenschicht (511) aus Isoliermaterial und einer oberen Schicht (510), bestehend aus mehreren Leiterbahnen aus leitenden Material, auf welche die Leistungshalbleiterkomponenten und die integrierten elektronischen Steuerschaltungen (3) gelötet sind, bestehen, und dadurch, dass die Verbindungselemente (512 bis 532) auf die Leiterbahnen der oberen Schicht (510) und/oder auf die Leistungshalbleiterkomponenten hartgelötet sind.

2. Architektur nach Anspruch 1, **dadurch gekennzeichnet, dass** die integrierten elektronischen Steuerschaltungen (3) in der Form anwendungsspezifischer integrierter Schaltungen nach der sogenannten ASIC Technologie hergestellt sind, die auf den Substraten implementiert sind.

3. Architektur nach einem der Ansprüche 1 oder 2, **dadurch gekennzeichnet, dass**, wenn die rotierende Maschine (*Mt*) vom Typ eines Mehrphasengenerators ist, der einen Rotor (*R*) umfasst, der mit einer Wicklung für jede Phase (ϕ) versehen ist, wobei jede Wicklung einen Wechselstrom erzeugt, die Leistungshalbleiterkomponenten jedes der Leistungsmodule (51 bis 53) zwei der Zweige (*B*) einer synchronen Mehrphasengleichrichterbrücke (2) bilden und die integrierten elektronischen Steuerschaltungen (3) Schaltungen sind, die in jedem der Leistungsmodule (51 bis 53) verteilt sind, um geformte Steuersignale für jeden der Brückenzweige (B) zu erzeugen.

4. Architektur nach Anspruch 3, **dadurch gekennzeichnet, dass** die Leistungshalbleiterkomponenten MOSFET-Transistoren sind.

5. Architektur nach einem der vorhergehenden Ansprüche, **dadurch gekennzeichnet, dass** der Verbinder (6) und der Kühlkörper (4) mechanisch aneinander befestigt sind (44, 61).

6. Mehrphasige rotierende Maschine, **dadurch gekennzeichnet, dass** sie eine Architektur miteinander verbundener elektronischer Leistungsmodule (51 bis 53) nach einem der vorhergehenden Ansprüche umfasst.

7. Mehrphasige rotierende Maschine nach dem vorhergehenden Anspruch, **dadurch gekennzeichnet, dass** der Verbinder (6) und der Kühlkörper (4) mechanisch aneinander (44, 61) und an einem oberen mechanischen Teil (7) der rotierenden Maschine (Mt) befestigt sind.

8. Mehrphasige rotierende Maschine nach Anspruch 7, **dadurch gekennzeichnet, dass** der obere mechanische Teil (7) Öffnungen aufweist, die um einen mittleren Bereich (70) herum angeordnet sind und Umgebungsluft eintreten lassen, um die inneren Organe der rotierenden Maschine zu kühlen, und dadurch, dass der Verbinder (6) und der Kühlkörper (4) die Umfangsfläche des oberen mechanischen Teils (7) auf einem Kreisbogen bedecken, so dass sie in dem mittleren Bereich einen freien Durchgang für die Umgebungsluft lassen.

## Claims

1. Architecture of interconnected power electronic modules for a polyphase rotary machine (*Mt*), comprising at least two electrically interconnected power modules (51 to 53), a connector (6) including at least one layer composed of a plurality of conductive signal or power tracks (64) borne by at least one wafer (62, 63) made of an insulating material in order to interconnect said power modules (51 to 53) together, and also to interconnect said power modules (51 to 53) with electrical elements (phases ϕ, *B*+, *B*-) of said rotary machine (*Mt*), and a heat sink (4), said architecture being **characterized in that** said power modules (51 to 53) include a plurality of connecting elements (512 to 532) that are electrically connected, at a first end, to components (510 to 530) of said power modules and, at a second end, to one of said conductive tracks (64) of the connector (6), **in that** the heat sink (4) is provided with open cavities (41 to 43) that are each intended to receive one of said power modules (51 to 53), said power modules (51 to 53) each comprise a substrate on which power semiconductor components and integrated electronic control circuits (3) for controlling these components are implemented, and **in that** each of said substrates is bonded to the bottom wall of one of said open cavities (41 to 43), said open cavities (41 to 43) being filled with insulating gel after the bonding of said substrates, **in that** said connector (6) comprises at least one layer of conductive tracks (64) sandwiched between two wafers (62, 63) made of an insulating material, and **in that** said conductive tracks (64) comprise high-power connections conveying currents referred to as "high" currents in order to interconnect said power semiconductor components and determined electrical elements (phases ϕ, *B*+, *B*-) of said rotary machine (*Mt*) together, and low-power connections conveying control signals in order to interconnect said integrated electronic control circuits (3), said substrates being produced using direct bonded copper technology, referred to as "DBC" technology, and are composed of at least one lower layer (513) made of a conductive material, one intermediate layer (511) made of an insulating material and one upper layer (510) composed of a plurality of tracks made of a conductive material to which said power semiconductor components and said integrated electronic control circuits (3) are soldered, and **in that** said connecting elements (512 to 532) are welded to said tracks of the upper layer (510) and/or to said power semiconductor components.

2. Architecture according to Claim 1, **characterized in that** said integrated electronic control circuits (3) are produced in the form of specialized integrated circuits using the technology referred to as "ASIC" technology, which circuits are implemented on said substrates.

3. Architecture according to either one of Claims 1 and 2, **characterized in that**, said rotary machine (*Mt*) being a polyphase alternator-type rotary machine comprising a rotor (*R*) provided with one winding for each phase (ϕ), each winding generating an alternating current, said power semiconductor components of each one of said power modules (51 to 53) form two of the arms (*B*) of a synchronous polyphase bridge rectifier (2), and said integrated electronic control circuits (3) are circuits distributed across each of said power modules (51 to 53), so as to generate shaped control signals for each of said bridge arms (B).

4. Architecture according to Claim 3, **characterized in that** said power semiconductor components are MOSFET transistors.

5. Architecture according to any one of the preceding claims, **characterized in that** said connector (6) and said heat sink (4) are mechanically attached to one another (44, 61).

6. Polyphase rotary machine, **characterized in that** it comprises an architecture of interconnected power electronic modules (51 to 53) according to any one of the preceding claims.

7. Polyphase rotary machine according to the preceding claim, **characterized in that** said connector (6) and said heat sink (4) are mechanically attached to one another (44, 61) and to an upper mechanical portion (7) of said rotary machine (*Mt*).

8. Polyphase rotary machine according to Claim 7, **characterized in that** said upper mechanical portion (7) includes orifices that are formed around a central zone (70) and allow ambient air to enter in order to cool the internal members within said rotary machine, and **in that** said connector (6) and said heat sink (4) cover the peripheral surface of said upper mechanical portion (7) over a circular arc so as to allow said ambient air to flow freely into said central zone.
